(19) Europäisches Patentamt / European Patent Office / Office européen des brevets

(11) **EP 4 671 777 A1**

(12) **EUROPEAN PATENT APPLICATION**
published in accordance with Art. 153(4) EPC

(43) Date of publication:
**31.12.2025 Bulletin 2026/01**

(21) Application number: **23927235.4**

(22) Date of filing: **25.12.2023**

(51) International Patent Classification (IPC):
*G01R 31/28* (2006.01)

(52) Cooperative Patent Classification (CPC):
**G01R 1/02; G01R 31/28**

(86) International application number:
**PCT/CN2023/141457**

(87) International publication number:
**WO 2024/187895 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.03.2023 CN 202310261232**

(71) Applicant: **Huawei Technologies Co., Ltd.
Shenzhen, Guangdong 518129 (CN)**

(72) Inventors:
• **JIAO, Huifang
  Shenzhen, Guangdong 518129 (CN)**

• **WAN, Jun
  Shenzhen, Guangdong 518129 (CN)**
• **ZHU, Guoliang
  Shenzhen, Guangdong 518129 (CN)**
• **DONG, Wei
  Shenzhen, Guangdong 518129 (CN)**
• **ZHOU, Xue
  Shenzhen, Guangdong 518129 (CN)**

(74) Representative: **Maiwald GmbH
Engineering
Elisenhof
Elisenstrasse 3
80335 München (DE)**

(54) **CHIP AGING METHOD AND DEVICE**

(57) A chip aging method and apparatus are provided. The aging apparatus (204) is connected to a drive circuit of a chip, and the drive circuit includes an inverter (N1) and at least one selection transistor. The apparatus is connected to an input end of the inverter (N1) and a gate of the selection transistor, an output end of the inverter (N1) is connected to a drain of the selection transistor, a source of the selection transistor and a second power supply end (Vbb) of the inverter (N1) are connected to a low voltage, and a first power supply end (Vhigh) of the inverter (N1) is connected to a high voltage. The method includes: outputting a first level, used to form a direct current field between an input and an output of the inverter (N1), to the inverter (N1); or outputting a second level, used to control the first power supply end (Vhigh) and the output end to be connected, to the inverter (N1), and outputting a third level, used to form a direct current field between the source and the drain of the selection transistor, to the gate of the selection transistor, so that a drive circuit having a quality problem fails after accelerated aging, thereby avoiding a row or multi-row failure of a chip caused by time-dependent dielectric breakdown or hot carrier degradation of a drive circuit after delivery.

FIG. 2

**Description**

CROSS-REFERENCE TO RELATED APPLICATIONS

This application claims priority to Chinese Patent Application No. 202310261232.1, filed with the China National Intellectual Property Administration on March 13, 2023 and entitled "CHIP AGING METHOD AND APPARATUS", which is incorporated herein by reference in its entirety.

TECHNICAL FIELD

This application relates to the semiconductor detection field, and in particular, to a chip aging method and apparatus.

BACKGROUND

At present, a fault of a drive circuit of a chip often causes a row or multi-row failure of the chip. For example, a drive circuit of a dynamic random access memory (dynamic random access memory, DRAM) chip is provided with multiple sub-wordlines, and each sub-wordline is connected to multiple memory cells. If the drive circuit is faulty, the memory cell connected to the sub-wordline cannot receive a drive voltage, resulting in a row or multi-row failure of the chip.

However, an existing aging test method cannot stimulate a row or multi-row failure of a type of storage chip such as the DRAM. As a result, a defective chip having a potential problem enters into the market, resulting in a decrease in reliability of a computer device using the defective chip.

Therefore, for a row or multi-row failure problem of a chip, how to improve a speed and accuracy of chip aging detection is an urgent problem to be resolved currently.

SUMMARY

This application provides a chip aging method and apparatus, to improve a speed and accuracy of chip aging detection.

According to a first aspect, this application provides a chip aging method. A drive circuit of a chip includes an inverter and at least one selection transistor.

An aging apparatus is connected to an input end of the inverter and a gate of the at least one selection transistor, an output end of the inverter is connected to a drain of the at least one selection transistor, a first power supply end of the inverter is connected to a high voltage, and a second power supply end of the inverter and a source of each selection transistor are connected to a low voltage.

The aging method includes:
the aging apparatus outputs a first level to the inverter, where the first level is used to form a direct current field between the input end and the output end of the inverter.

Alternatively, the aging method includes:

the aging apparatus outputs a second level to the inverter, where the second level is used to control a path between the first power supply end and the output end to be connected, and
outputs a third level to the gate of the selection transistor, where the third level is used to form a direct current field between the source and the drain of the selection transistor.

Based on the foregoing solution, the inverter inputs the first level. Because a reverse level is output due to an inversion function of the inverter, a maximum electric potential difference is formed between the input end and the output end of the inverter, that is, a maximum electric field is formed at a dielectric layer. The maximum electric field can accelerate time-dependent dielectric breakdown at the dielectric layer and accelerate aging of the drive circuit.

In a conventional chip aging solution, an alternating current is used to continuously change the level at the input end of the inverter, and consequently an electric field applied to the dielectric layer is changed, that is, an alternating current stress. However, in the technical solution of this application, the level is maintained to be stable, and the input level at the input end of the inverter is not changed. This is equivalent to that an applied electric field is an electric field of a direct current property, that is, a direct current stress. Acceleration effect of the direct current stress on TDDB is greater than that of the alternating current stress. Therefore, the solution can further accelerate aging of the drive circuit.

In addition, based on the foregoing solution, after the aging apparatus controls the path between the first power supply end and the output end to be connected, a voltage of the drain of the selection transistor is the high voltage. In addition, the aging apparatus outputs the third level to control the path between the source and the drain of the selection transistor to be connected. However, the source of the selection transistor is connected to the low voltage. Therefore, there is a maximum voltage difference between the source and the drain of the selection transistor, and a maximum electric field is formed to accelerate hot carrier degradation, thereby accelerating aging of the drive circuit.

In addition, because the electric field applied between the source and the drain of the selection transistor is the electric field of a direct current property, that is, the direct current stress, and acceleration effect of the direct current stress on HCI is greater than that of the alternating current stress, aging of the drive circuit can be further accelerated.

In conclusion, according to the chip aging method in this application, aging of the drive circuit in the chip can be accelerated, so that a drive circuit having a quality problem fails after aging, thereby improving a speed and accuracy of chip detection, and avoiding a row or multi-row failure in the chip after delivery.

In an implementation, when the aging apparatus outputs the first level to the inverter, the method further includes: the aging apparatus outputs a fourth level to the gate of the selection transistor, where the fourth level is used to control a path between the source and the drain of the selection transistor to be disconnected.

Based on the foregoing solution, a change of a voltage of the output end of the inverter caused by connecting of the source and the drain of the selection transistor is avoided, and stability of the direct current field at the dielectric layer is further ensured.

In an implementation, when the aging apparatus outputs the first level to the inverter, the method further includes: the aging apparatus adjusts an ambient temperature of the drive circuit to be higher than a first preset temperature, where the first preset temperature is an operating temperature of the drive circuit.

Because a higher temperature indicates shorter failure time of TDDB occurring at the dielectric layer, in this solution, the drive circuit is placed in an environment higher than the operating temperature of the drive circuit, that is, a high temperature condition is formed, to accelerate time-dependent dielectric breakdown and accelerate aging of the drive circuit.

In an implementation, when the aging apparatus outputs the second level to the inverter, the method further includes:

the aging apparatus adjusts the ambient temperature of the drive circuit to be lower than a second preset temperature, where the second preset temperature is a normal temperature.

Because a lower temperature indicates shorter time of HCI occurring at the selection transistor, in this solution, the drive circuit is placed in an environment lower than the normal temperature, for example, 25°C, that is, a low-temperature condition is formed, to accelerate hot carrier degradation and accelerate aging of the drive circuit.

According to a second aspect, this application provides a chip aging method. A drive circuit of a chip includes an inverter, a position decoder, and at least one selection transistor.

An aging apparatus is connected to an input end of the inverter and a first end of the position decoder, a second end of the position decoder is connected to a gate of the at least one selection transistor, an output end of the inverter is connected to a drain of the at least one selection transistor, a first power supply end of the inverter is connected to a high voltage, and a second power supply end of the inverter and a source of each selection transistor are connected to a low voltage.

The aging method includes:
the aging apparatus outputs a first level to the inverter, where the first level is used to form a direct current field between the input end and the output end of the inverter.

Alternatively, the aging method includes:

the aging apparatus outputs a second level to the inverter, where the second level is used to control a path between the first power supply end and the output end to be connected, and
controls the position decoder to output a third level to the gate of the selection transistor, where the third level is used to form a direct current field between the source and the drain of the selection transistor.

In an implementation, when the aging apparatus outputs the first level to the inverter, the method further includes: the aging apparatus controls the position decoder to output a fourth level to the gate of the selection transistor, where the fourth level is used to control a path between the source and the drain of the selection transistor to be disconnected.

In an implementation, when the aging apparatus outputs the first level to the inverter, the method further includes: the aging apparatus adjusts an ambient temperature of the drive circuit to be higher than a first preset temperature, where the first preset temperature is an operating temperature of the drive circuit.

In an implementation, when the aging apparatus outputs the second level to the inverter, the method further includes:

the aging apparatus adjusts the ambient temperature of the drive circuit to be lower than a second preset temperature, where the second preset temperature is a normal temperature.

According to a third aspect, this application provides an aging apparatus. The aging apparatus includes a controller and a level output unit, and the aging apparatus is connected to a drive circuit of a chip.

The drive circuit includes an inverter and at least one selection transistor.

The controller is connected to the level output unit, the level output unit is connected to an input end of the inverter and a gate of the at least one selection transistor, an output end of the inverter is connected to a drain of the at least one selection transistor, a first power supply end of the inverter is connected to a high voltage, and a second power supply end of the inverter and a source of each selection transistor are connected to a low voltage.

The level output unit is configured to output a level.

The controller is configured to control the level output unit to output a first level to the inverter, where the first level is used to form a direct current field between the input end and the output end of the inverter.

Alternatively, the controller is configured to: control the level output unit to output a second level to the inverter, where the second level is used to control a path between the first power supply end and the output end to be connected, and control the level output unit to output a third level to the gate of the selection transistor, where the third level is used to form a direct current field between the source and the drain of the selection transistor.

In an implementation, when controlling the level output unit to output the first level to the inverter, the controller is further configured to:

control the level output unit to output a fourth level to the gate of the selection transistor, where the fourth level is used to control a path between the source and the drain of the selection transistor to be disconnected.

In an implementation, the aging apparatus further includes a temperature control layer, and the temperature control layer is configured to provide an ambient temperature for the drive circuit.

In an implementation, when controlling the level output unit to output the first level to the inverter, the controller is further configured to:

adjust a temperature of the temperature control layer to be higher than a first preset temperature, where the first preset temperature is an operating temperature of the drive circuit.

In an implementation, when controlling the level output unit to output the second level to the inverter, the controller is further configured to:

adjust the temperature of the temperature control layer to be higher than and lower than a second preset temperature, where the second preset temperature is a normal temperature.

According to a fourth aspect, this application provides an aging apparatus. The aging apparatus includes a controller and a level output unit, and the aging apparatus is connected to a drive circuit of a chip.

The drive circuit includes an inverter, a position decoder, and at least one selection transistor.

The controller is connected to the level output unit and a first end of the position decoder, a second end of the position decoder is connected to a gate of the at least one selection transistor, the level output unit is connected to an input end of the inverter, an output end of the inverter is connected to a drain of the at least one selection transistor, a first power supply end of the inverter is connected to a high voltage, and a second power supply end of the inverter and a source of each selection transistor are connected to a low voltage.

The level output unit is configured to output a level.

The controller is configured to control the level output unit to output a first level to the inverter, where the first level is used to form a direct current field between the input end and the output end of the inverter.

Alternatively, the controller is configured to: control the level output unit to output a second level to the inverter, where the second level is used to control a path between the first power supply end and the output end to be connected, and control the position decoder to output a third level to the gate of the selection transistor, where the third level is used to form a direct current field between the source and the drain of the selection transistor.

In an implementation, when controlling the level output unit to output the first level to the inverter, the controller is further configured to:

control the position decoder to output a fourth level to the gate of the selection transistor, where the fourth level is used to control a path between the source and the drain of the selection transistor to be disconnected.

In an implementation, the aging apparatus further includes a temperature control layer, and the temperature control layer is configured to provide an ambient temperature for the drive circuit.

In an implementation, when controlling the level output unit to output the first level to the inverter, the controller is further configured to:

adjust a temperature of the temperature control layer to be higher than a first preset temperature, where the first preset temperature is an operating temperature of the drive circuit.

In an implementation, when controlling the level output unit to output the second level to the inverter, the controller is further configured to:

adjust the temperature of the temperature control layer to be higher than and lower than a second preset temperature, where the second preset temperature is a normal temperature.

According to a fifth aspect, this application further provides a computer device. The computer device includes a memory and a processor, the memory stores a computer program, and when executing the computer program, the processor implements the chip aging method according to the first aspect or the second aspect.

According to a sixth aspect, this application further provides a computer storage medium. The computer storage medium stores a computer program, and when the computer program is executed by a processor, the chip aging method according to the first aspect or the second aspect may be implemented.

BRIEF DESCRIPTION OF DRAWINGS

FIG. 1 is a diagram of a structure of a drive circuit of a DRAM chip;
FIG. 2 is a diagram of a structure of a drive circuit according to an embodiment of this application;
FIG. 3 is a diagram of a structure of another drive circuit according to an embodiment of this application;
FIG. 4 is a simulation diagram of an acceleration test according to an embodiment of this application;
FIG. 5 is a diagram of a structure of another drive circuit according to an embodiment of this application;
FIG. 6 is a diagram of a structure of an aging apparatus according to an embodiment of this application;
FIG. 7 is a diagram of a structure of another aging apparatus according to an embodiment of this application; and
FIG. 8 is a diagram of a structure of a computer device according to an embodiment of this application.

DESCRIPTION OF EMBODIMENTS

To make the objectives, technical solutions, and advantages of this application clearer, the following clearly and completely describes the technical solutions in embodiments of this application with reference to the accompanying drawings in embodiments of this application.

For ease of understanding embodiments of this application, the following first describes terms included in embodiments of this application.

1. Chip aging detection

Chip aging detection is an electrical stress test method that uses voltage and temperature changes to accelerate an electrical fault of a component. The detection process basically simulates to run an actual aging process of a chip. Aging of the chip is accelerated, so that a chip having a quality problem fails after aging to detect reliability of the component or detect an early fault of the component.

2. Time-dependent dielectric breakdown (time-dependent dielectric breakdown, TDDB)

Time-dependent dielectric breakdown TDDB means that a strength of an electric field applied to a dielectric layer is lower than an intrinsic breakdown field strength of the dielectric layer, and does not cause intrinsic breakdown. However, after a period of time, breakdown is caused because traps are generated and accumulated at the dielectric layer in a process of applying an electrical stress.

For example, it is assumed that aging and breakdown of an oxide layer are a thermodynamic process. Under actions of a thermal stress and an applied electric field, an angle of a silicon-oxygen covalent bond Si-O-Si is increased, from an initial 120° angle to more than 150° angle, to form an oxygen vacancy structure, and a Si-Si weak bond occurs. After the Si-Si bond is broken, a hole trap appears. Breakage of the covalent bond is accelerated under an action of an enhanced electric field, thereby leading to breakdown of the oxide layer.

3. Hot carrier injection (hot carrier injection, HCI)

HCI effect in a metal-oxide-semiconductor (metal-oxide-semiconductor, MOS) transistor is brought by continuous reduction of a feature size of a component. An input voltage of the component does not decrease proportionally, so that transverse and longitudinal electric fields in a channel increase significantly, and the high electric field accelerates movement of a carrier, thereby changing the carrier into a hot carrier having high energy. When the carrier energy is large enough, the carrier can be directly injected or penetrated into silicon dioxide $SiO_2$ to form a charge trap, resulting in a cut-off voltage drift and a linear region transconductance drift of the MOS transistor.

In addition, it should be understood that in the descriptions of this application, terms such as "first" and "second" are only used for description differentiation, but cannot be understood as indication or implication of relative importance and cannot be understood as indication or implication of sequences; "and/or describes an association relationship for describing associated objects, and represents that three relationships may exist. For example, A and/or B may represent the following three cases: Only A exists, both A and B exist, and only B exists. The character "/" generally indicates an "or" relationship between associated objects; "a plurality of" means two or more.

To make the objectives, technical solutions, and advantages of this application clearer, the following further describes this application in detail with reference to the application background.

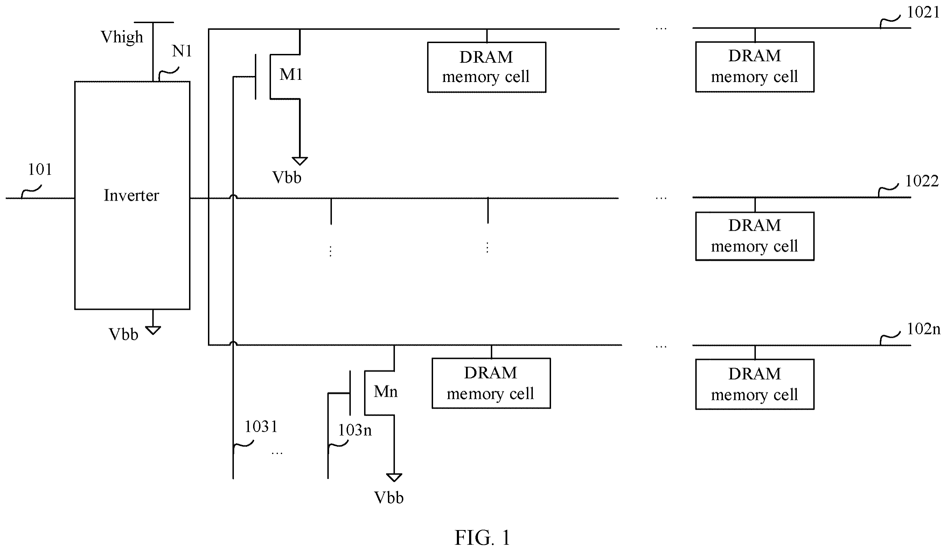

At present, a failure of a drive circuit of a chip often causes a row or multi-row failure of the chip. A dynamic random access memory (dynamic random access memory, DRAM) chip is used as an example. During producing, to improve a memory cell density of the DRAM, a wordline drive circuit is usually provided with multiple sub-wordlines, and each sub-wordline is connected to multiple memory cells. As shown in FIG. 1, the DRAM drive circuit includes a first wordline 101, a second wordline (shown by 1021 to 102n in FIG. 1), at least one selection line (shown by 1031 to 103n in FIG. 1), an inverter N1, and at least one selection transistor (M1 to Mn are shown in FIG. 1), and each second wordline is connected to multiple DRAM memory cells.

Once the DRAM drive circuit shown in FIG. 1 is faulty, the DRAM memory cell connected to the second wordline cannot receive a drive voltage, resulting in a row or multi-row failure of the chip.

However, in a manufacturing process of the DRAM chip, the first wordline and the second wordline are distributed at different layers, and are connected through a metal contact (metal contact, MC) hole, and a wiring spacing is extremely small. A fault of short-circuiting between the metal contact hole and the wordline and nonalignment of the metal contact hole frequently occur, so that a risk of occurring TDDB is sharply increased, and consequently a driving capability of the drive circuit is reduced.

In addition, in a use process, a voltage difference between the source and the drain of the selection transistor is usually large, so that a risk of occurring HCI is sharply increased, and consequently a driving capability of the drive circuit is reduced.

However, a current chip aging test method cannot stimulate a failure of a drive circuit of a type of chip such as the DRAM. As a result, a defective chip having a potential problem enters into the market, resulting in a decrease in reliability of a computer device using the defective chip.

Therefore, how to improve a speed and accuracy of chip aging detection for a row or multi-row failure of a chip is an urgent problem to be resolved currently.

Based on the foregoing problem, embodiments of this application provide a chip aging method and apparatus, to improve a speed and accuracy of chip aging detection.

The following describes, with reference to the foregoing described application scenario and the accompanying drawings, the chip aging method provided in example implementations of this application. It should be noted that the foregoing application scenario is merely shown for ease of understanding a principle of this application, an implementation of this application is not limited in this aspect.

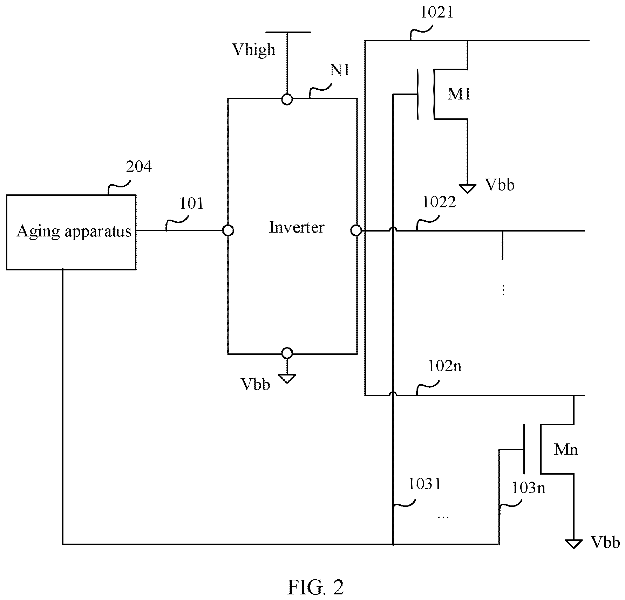

As shown in FIG. 2, a drive circuit in this application includes an inverter N1 and at least one selection transistor.

An aging apparatus 204 is connected to an input end of the inverter N1 through a first wordline 101, the aging apparatus 204 is connected to a gate of the at least one selection transistor through a selection line, and a first power supply end Vhigh of the inverter N1 is connected to a high voltage. An output end of the inverter N1 is connected to a drain of the at least one selection transistor through a second wordline, a second power supply end Vbb of the inverter N1 and a source of each selection transistor are connected to a low voltage.

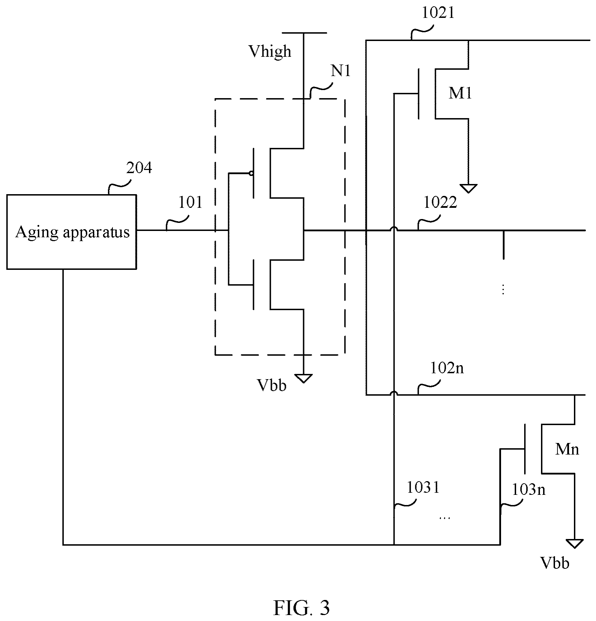

For example, as shown in FIG. 3, the inverter N1 includes a P-type transistor and an N-type transistor (in FIG. 3, a transistor at the upper part of the inverter N1 is the P-type transistor, and a transistor at the lower part of the inverter N1 is the N-type transistor). A gate of the P-type transistor is connected to a gate of the N-type transistor, to form the input end of the inverter N1. A source of the P-type transistor is connected to a drain of the N-type transistor, to form the output end of the inverter N1. A drain of the P-type transistor forms the first power supply end Vhigh of the inverter N1. A source of the N-type transistor forms the second power supply end Vbb of the inverter N1.

The following describes, with reference to a structure of the drive circuit, a principle of accelerating to stimulate time-dependent dielectric breakdown TDDB.

When a thickness of a field oxidized layer between the first wordline and the second wordline is far greater than 5 nm, time-dependent dielectric breakdown generally complies with a thermochemical breakdown model, and the thermochemical breakdown model is shown in Formula 1:

$$\text{TTF} = A\, e^{-\gamma E_{ox}} * e^{\frac{E_a}{kT}} \qquad\qquad \text{Formula 1}$$

TTF represents failure time, A is a constant related to a material and a process, $\gamma$ is an electric field acceleration factor related to a temperature, $E_{ox}$ is an electric field applied to a dielectric layer, $E_a$ is activation energy, that is, energy required for a crystal atom to move from a balanced position to another new balanced or unbalanced position, that is, energy that needs to be overcome to start a physical chemical process, k is a Boltzmann constant, and T represents a temperature.

It can be learned from Formula 1 that:

The failure time TTF caused by time-dependent dielectric breakdown is mainly affected by $E_{ox}$ and the

temperature T.

It should be noted that a dielectric layer represented by $E_{ox}$ may be a field oxidized layer, and a larger electric field applied to the dielectric layer indicates shorter failure time TTF. In addition, impact of the temperature T on TTF complies with the Aleynius equation, and a higher temperature T indicates shorter failure time TTF.

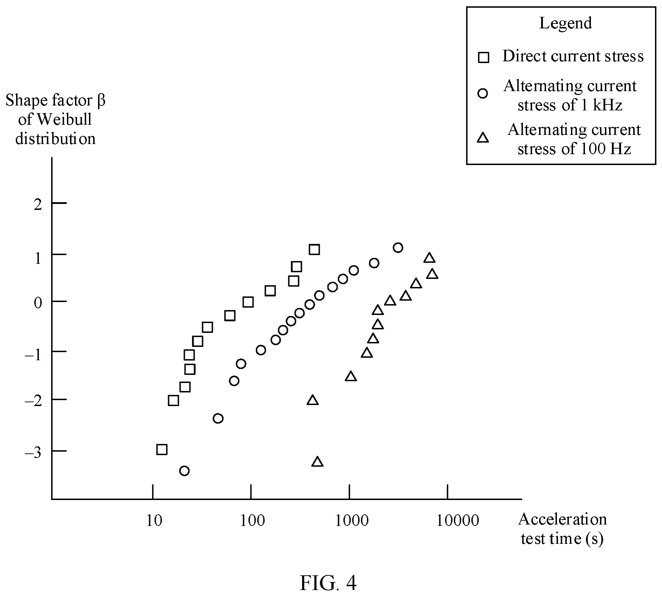

In addition, a direct current stress and an alternating current stress have different impact on the failure time of TDDB. A simulation diagram of an acceleration test shown in FIG. 4 is obtained by separately applying a direct current stress with a voltage of 2.9 V, a high-frequency alternating current stress with a voltage of 2.9 V, and a low-frequency alternating current stress with a voltage of 2.9 V to the input end of the inverter N1. As shown in FIG. 4, a frequency of the high-frequency alternating current stress is 1 kHz, and a frequency of the low-frequency alternating current stress frequency is 100 kHz. In the simulation diagram, a horizontal axis is acceleration test time, and a vertical axis is a shape factor β of Weibull distribution. A larger value of β indicates lower reliability and a higher failure rate.

It can be learned from FIG. 4 that, the failure time of TDDB of a dielectric is closely related to a change frequency of an applied electric field, that is, a frequency of the stress applied to the dielectric layer. Under same acceleration time, a voltage stress of a same magnitude is applied. A β value corresponding to the direct current stress is greater than a β value corresponding to the alternating current stress, and a β value corresponding to the high-frequency alternating current stress is greater than a β value corresponding to the low-frequency alternating current stress.

Therefore, compared with the high-frequency alternating current stress and the low-frequency alternating current stress, the direct current stress has a greatest function to accelerate to stimulate TDDB.

For example, for a DRAM chip whose operating frequency is 100 kHz and operating temperature is 55°C, an acceleration coefficient of the direct current stress may reach more than 100 times. When the activation energy $E_a$ of TDDB is 0.75 ev and an acceleration test temperature is 105°C, a temperature acceleration is about 33 times, and total acceleration effect of the high temperature and the direct current stress is about 3300 times.

The following describes a chip aging method in this application based on the foregoing principle of accelerating to stimulate TDDB.

Embodiment 1

The chip aging method in this application includes:
the aging apparatus 204 outputs a first level to the inverter N1.

It should be noted that the first level is used to form a direct current field between the input end and the output end of the inverter N1.

For example, the aging apparatus 204 outputs a high level to the inverter N1, and after an inversion action of the inverter N1, the output end of the inverter N1 outputs a low level. Therefore, a maximum voltage difference is formed at an oxide layer between the input end and the output end of the inverter N1, that is, a maximum electric field is formed. The electric field can accelerate to stimulate time-dependent dielectric breakdown, thereby accelerating aging of the drive circuit.

In addition, in a conventional DRAM chip aging method, an alternating current is used to continuously change the level at the input end of the inverter N1, and consequently an electric field applied to the dielectric layer continuously changes. Therefore, an alternating current stress is applied. However, in the technical solution disclosed in this application, the input level at the input end of the inverter N1 is maintained to be stable. This is equivalent to that an applied electric field is an electric field of a direct current property, that is, a direct current stress is applied. Therefore, time-dependent dielectric breakdown can further be accelerated to be stimulated, thereby accelerating aging of the drive circuit.

Embodiment 2

The chip aging method in this application includes:
the aging apparatus 204 outputs a first level to the inverter N1, and outputs a fourth level to the gate of the selection transistor.

It should be noted that the fourth level is used to control a path between the source and the drain of the selection transistor to be disconnected.

For example, the aging apparatus 204 outputs a high level to the inverter N1, and after an inversion action of the inverter N1, the output end of the inverter N1 outputs a low level. Therefore, a maximum electric field is formed between the input end and the output end of the inverter N1.

In addition, in the technical solution disclosed in this application, the input level at the input end of the inverter N1 is maintained to be stable. This is equivalent to that a direct current stress is applied.

In addition, for example, the selection transistor is an N-type transistor. The aging apparatus 204 outputs a low level, that is, the fourth level, to the gate of the selection transistor, and the path between the source and the drain of the selection transistor is disconnected, to avoid fluctuation of a voltage of the output end of the inverter caused by connecting of the source and the drain of the selection transistor, further ensure stability of a direct current field, and accelerate to stimulate time-dependent dielectric breakdown.

Embodiment 3

The chip aging method in this application includes:
the aging apparatus 204 outputs a first level to the inverter N1, outputs a fourth level to the gate of the selection transistor, and adjusts an ambient temperature of the drive circuit to be higher than a first preset temperature.

It should be noted that the first preset temperature is an operating temperature of the drive circuit, for example, 55°C.

For example, when the aging apparatus 204 controls the dielectric layer of the inverter to generate a direct current field, the ambient temperature of the drive circuit is adjusted to be higher than the operating temperature through greenhouse temperature adjustment, fan rotation speed reduction, and the like, to form a high temperature condition, thereby further accelerating to stimulate time-dependent dielectric breakdown.

The following describes, with reference to a structure of the drive circuit, a principle of accelerating to stimulate hot carrier injection HCI.

When channel lengths are the same, a larger voltage difference between the source and the drain of the selection transistor indicates a higher probability of occurring hot carrier degradation of the selection transistor. In addition, similar to the foregoing TDDB acceleration test, a direct current stress has a greater function to stimulate HCI than an alternating current stress.

In addition, a low temperature environment can stimulate hot carrier degradation of the selective transistor.

For example, for a DRAM chip whose operating frequency is 100 kHz and operating temperature is 55°C, when activation energy $E_a$ of hot carrier degradation is -0.2 ev, and an acceleration test temperature is -25°C, a temperature acceleration is about 10 times, and total acceleration effect of the low temperature and the direct current stress is about 500 to 1000 times.

The following describes a chip aging method in this application based on the foregoing principle of accelerating to stimulate HCI.

Embodiment 1

The chip aging method in this application includes:
the aging apparatus 204 outputs a second level to the inverter N1, and outputs a third level to the gate of the selection transistor.

It should be noted that, the second level is used to control a path between the first power supply end Vhigh and the output end to be connected, and the third level is used to form a direct current field between the source and the drain of the selection transistor.

For example, as shown in FIG. 3, the first power supply end Vhigh is connected to a high voltage of 3.8 V, and a voltage of the second power supply end Vbb is connected to a low voltage of -0.3 V. The aging apparatus 204 applies a low level, that is, the second level, to the inverter N1, to control a voltage of the drain of the selection transistor to be 3.8 V. The aging apparatus 204 outputs a high level, that is, the third level, to the gate of the selection transistor, to control the path between the source and the drain of the selection transistor to be connected. Because the source of the selection transistor is connected to -0.3 V, a maximum voltage difference 4.1 V is formed between the source and the drain of the selection transistor, that is, a maximum electric field is formed. The electric field can accelerate to simulate hot carrier degradation, thereby accelerating aging of the drive circuit.

In addition, during HCI aging processing performed on the drive circuit, in this application, the second level and the third level are maintained to be stable. This is equivalent to that an electric field applied to the selection transistor is an electric field of a direct current property, that is, a direct current stress. Because the direct current stress has a greater function to accelerate to stimulate hot carrier degradation than an alternating current stress, aging of the drive circuit can be further accelerated.

Embodiment 2

The chip aging method in this application includes:
the aging apparatus 204 outputs a second level to the inverter N1, outputs a third level to the gate of the selection transistor, and adjusts an ambient temperature of the drive circuit to be lower than a second preset temperature.

It should be noted that the second preset temperature is a normal temperature, for example, 25°C.

For example, when the aging apparatus 204 controls a direct current field to be formed between the source and the drain of the selection transistor, the ambient temperature of the drive circuit is adjusted to be lower than the normal temperature through greenhouse temperature adjustment, fan rotation speed reduction, and the like, to form a low temperature condition, thereby further accelerating to simulate hot carrier degradation.

In conclusion, based on the principle of accelerating to simulate TDDB and the principle of accelerating to simulate HCI, the chip aging method disclosed in this application accelerates aging of the drive circuit by forming a maximum direct current field and adjusting the ambient temperature. A drive circuit having a quality problem fails after aging, thereby improving a speed and accuracy of chip aging detection, and avoiding a problem of a row or multi-row failure of the chip after delivery.

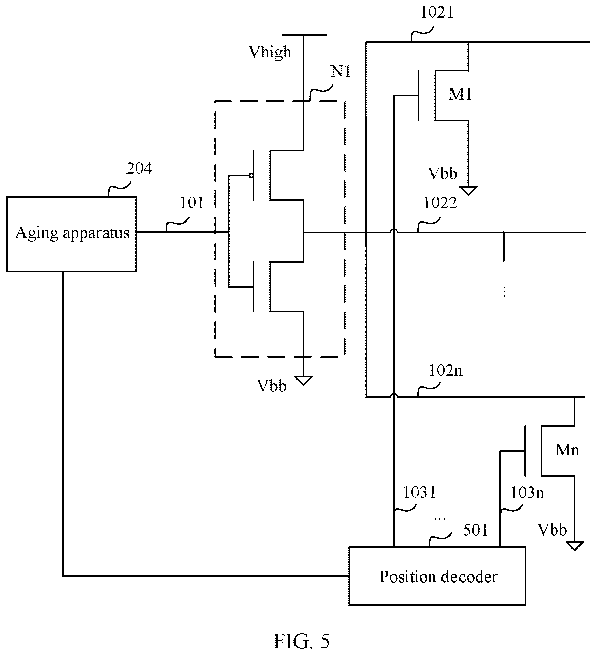

Based on a same technical concept, an embodiment of this application further provides a chip aging method. As shown in FIG. 5, a drive circuit of a chip includes an inverter N1, a position decoder 501, and at least one selection transistor.

An aging apparatus 204 is connected to an input end of the inverter N1 and a first end of the position decoder 501, a second end of the position decoder 501 is connected to a gate of the at least one selection transistor, an output end of the inverter N1 is connected to a drain of the at least one selection transistor, a first power supply end Vhigh of the inverter N1 is connected to a high voltage, and a second power supply end of the inverter N1 and a source of each selection transistor are connected to a low voltage.

The following describes another chip aging method in this application based on the foregoing principle of accelerating to stimulate TDDB.

Embodiment 1

The chip aging method in this application includes:
the aging apparatus 204 outputs a first level to the inverter N1.

For example, the aging apparatus 204 outputs a high level to the inverter N1, and after an inversion action of the inverter N1, the output end of the inverter N1 outputs a low level. Therefore, a maximum voltage difference is formed at an oxide layer between the input end and the output end of the inverter N1, that is, a maximum electric field is formed. The electric field can accelerate to stimulate time-dependent dielectric breakdown, thereby accelerating aging of the drive circuit.

In addition, in the technical solution disclosed in this application, the input level at the input end of the inverter N1 is maintained to be stable. This is equivalent to that an applied electric field is an electric field of a direct current property, that is, a direct current stress is applied. Therefore, time-dependent dielectric breakdown can further be accelerated to be stimulated, thereby accelerating aging of the drive circuit.

Embodiment 2

The chip aging method in this application includes:
the aging apparatus 204 outputs a first level to the inverter N1, and controls the position decoder 501 to output a fourth level to the gate of the selection transistor.

For example, the aging apparatus 204 outputs a high level to the inverter N1, and after an inversion action of the inverter N1, the output end of the inverter N1 outputs a low level. Therefore, a maximum electric field is formed between the input end and the output end of the inverter N1.

In addition, in the technical solution disclosed in this application, the input level at the input end of the inverter N1 is maintained to be stable. This is equivalent to that a direct current stress is applied.

In addition, for example, the selection transistor is an N-type transistor. The position decoder 501 outputs a low level, that is, the fourth level, to the gate of the selection transistor based on a control signal of the aging apparatus 204, and the path between the source and the drain of the selection transistor is disconnected, to avoid fluctuation of a voltage of the output end of the inverter caused by connecting of the source and the drain of the selection transistor, further ensure stability of a direct current field, and accelerate to stimulate time-dependent dielectric breakdown.

Embodiment 3

The chip aging method in this application includes:
the aging apparatus 204 outputs a first level to the inverter N1, outputs a fourth level to the gate of the selection transistor, and adjusts an ambient temperature of the drive circuit to be higher than a first preset temperature.

It should be noted that the first preset temperature is an operating temperature of the drive circuit, for example, 55°C.

For example, when the aging apparatus 204 controls the dielectric layer of the inverter to generate a direct current field, the ambient temperature of the drive circuit is adjusted to be higher than the operating temperature through greenhouse temperature adjustment, fan rotation speed reduction, and the like, to form a high temperature condition, thereby further accelerating to stimulate time-dependent dielectric breakdown.

The following describes another chip aging method in this application based on the foregoing principle of accelerating to stimulate HCI.

Embodiment 1

The chip aging method in this application includes:
the aging apparatus 204 outputs a second level to the inverter N1, and controls the position decoder 501 to output a third level to the gate of the selection transistor.

For example, the aging apparatus 204 applies a low level, that is, the second level, to the inverter N1, to control a voltage of the drain of the selection transistor is a high voltage. The aging apparatus 204 outputs a control signal to the position decoder 501, where the control signal is used to indicate the position decoder 501 to output the third level to gates of selection transistors M1 to M6, so that paths between sources and drains of the selection transistors are connected.

In this case, a maximum voltage difference is formed between the source and the drain of the selected transistor, that is, a maximum electric field is formed. The electric field can accelerate to simulate hot carrier degradation, thereby accelerating aging of the drive circuit.

In addition, during HCI aging processing performed on the drive circuit, in this application, the second level and the third level are maintained to be stable. This is equivalent to that an electric field applied to the selection transistor is an electric field of a direct current property, that is, a direct current stress. Because the direct current stress has a greater function to accelerate to stimulate hot carrier degradation than an alternating current stress, aging of the drive circuit can be further accelerated.

Embodiment 2

The chip aging method in this application includes:
the aging apparatus 204 outputs a second level to the inverter N1, controls the position decoder 501 to output a third level to the gate of the selection transistor, and adjusts an ambient temperature of the drive circuit to be lower than a second preset temperature.

It should be noted that the second preset temperature is a normal temperature, for example, 25°C.

For example, the aging apparatus 204 outputs the second level to the inverter N1, and controls the position decoder 501 to output the third level to the gate of the selection transistor, so that a path between the source and the drain of the selection transistor is connected, and a maximum direct current field is formed between the source and the drain of the selection transistor.

In addition, the aging apparatus 204 adjusts the ambient temperature of the drive circuit to be lower than the normal temperature through greenhouse temperature adjustment, fan rotation speed reduction, and the like, to form a low temperature condition, thereby further accelerating to simulate hot carrier degradation.

Based on a same technical concept, an embodiment of this application further provides an aging apparatus. For implementation of the apparatus, refer to the implementation of the foregoing chip aging method. Details are not described again.

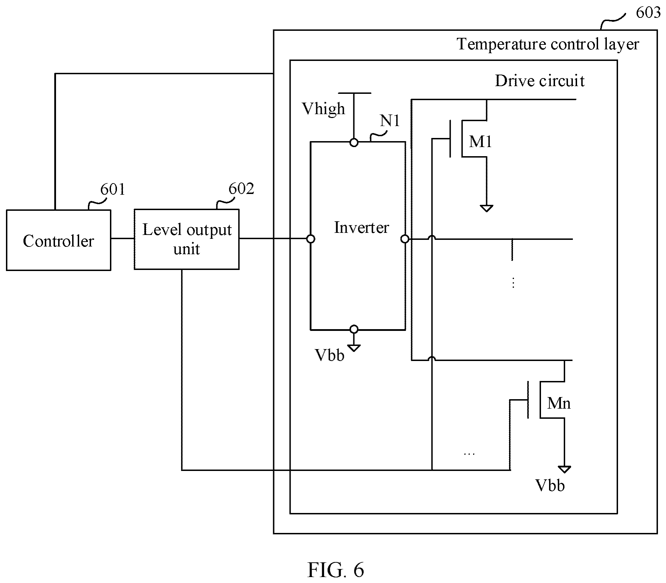

As shown in FIG. 6, the aging apparatus 204 includes a controller 601 and a level output unit 602. The aging apparatus 204 is connected to a drive circuit of a chip.

The drive circuit includes an inverter N1 and at least one selection transistor.

The controller 601 is connected to the level output unit 602, the level output unit 602 is connected to an input end of the inverter N1 and a gate of the at least one selection transistor, an output end of the inverter N1 is connected to a drain of the at least one selection transistor, a first power supply end Vhigh of the inverter N1 is connected to a high voltage, and a second power supply end of the inverter N1 and a source of each selection transistor are connected to a low voltage.

The level output unit 602 is configured to output a level.

The controller 601 is configured to control the level output unit 602 to output a first level to the inverter N1, where the first level is used to form a direct current field between the input end and the output end of the inverter N1.

Alternatively, the controller 601 is configured to: control the level output unit 602 to output a second level to the inverter N1, where the second level is used to control a path between the first power supply end Vhigh and the output end to be connected, and
control the level output unit 602 to output a third level to the gate of the selection transistor, where the third level is used to form a direct current field between the source and the drain of the selection transistor.

In an embodiment, when controlling the level output unit 602 to output the first level to the inverter N1, the controller 601 is further configured to:
control the level output unit 602 to output a fourth level to the gate of the selection transistor, where the fourth level is used to control a path between the source and the drain of the selection transistor to be disconnected.

In an embodiment, the aging apparatus 204 further includes a temperature control layer 603, and the temperature control layer 603 is configured to provide an ambient temperature for the drive circuit.

In an embodiment, when controlling the level output unit 602 to output the first level to the inverter N1, the controller 601 is further configured to:

adjust a temperature of the temperature control layer 603 to be higher than a first preset temperature, where the first preset temperature is an operating temperature of the drive circuit.

In an embodiment, when controlling the level output unit 602 to output the second level to the inverter N1, the controller 601 is further configured to:

adjust the temperature of the temperature control layer 603 to be higher than and lower than a second preset temperature, where the second preset temperature is a normal temperature.

Based on a same technical concept, an embodiment of this application further provides another aging apparatus. For implementation of the apparatus, refer to the implementation of the foregoing chip aging method. Details are not described again.

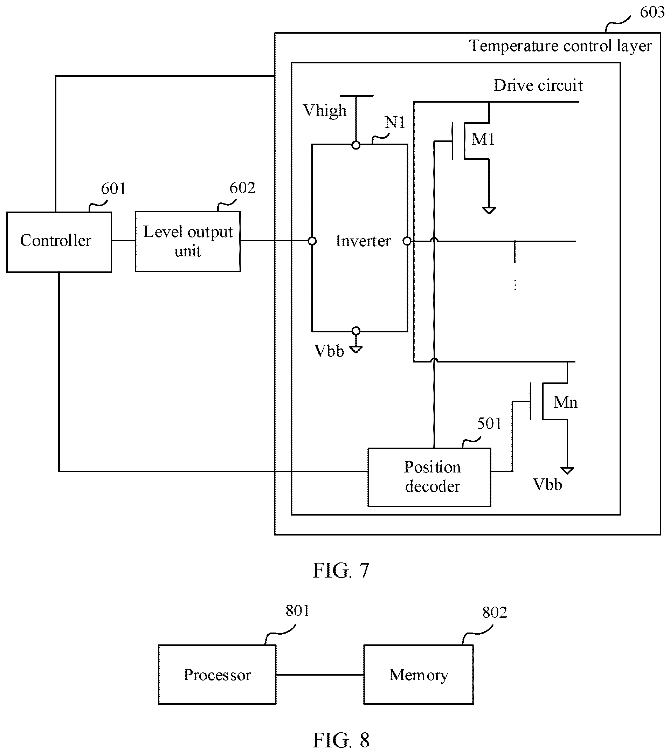

As shown in FIG. 7, the aging apparatus 204 includes a controller 601 and a level output unit 602. The aging apparatus 204 is connected to a drive circuit of a chip.

The drive circuit includes an inverter N1, a position decoder 501, and at least one selection transistor.

The controller 601 is connected to the level output unit 602 and a first end of the position decoder 501, a second end of the position decoder 501 is connected to a gate of the at least one selection transistor, the level output unit 602 is connected to an input end of the inverter N1, an output end of the inverter N1 is connected to a drain of the at least one selection transistor, a first power supply end Vhigh of the inverter N1 is connected to a high voltage, and a second power supply end of the inverter N1 and a source of each selection transistor are connected to a low voltage.

The level output unit 602 is configured to output a level.

The controller 601 is configured to control the level output unit 602 to output a first level to the inverter N1, where the first level is used to form a direct current field between the input end and the output end of the inverter N1.

Alternatively, the controller 601 is configured to: control the level output unit 602 to output a second level to the inverter N1, where the second level is used to control a path between the first power supply end Vhigh and the output end to be connected, and

control the position decoder 501 to output a third level to the gate of the selection transistor, where the third level is used to form a direct current field between the source and the drain of the selection transistor.

In an embodiment, when controlling the level output unit 602 to output the first level to the inverter N1, the controller 601 is further configured to:

control the position decoder 501 to output a fourth level to the gate of the selection transistor, where the fourth level is used to control a path between the source and the drain of the selection transistor to be disconnected.

In an embodiment, the aging apparatus 204 further includes a temperature control layer 603, and the temperature control layer 603 is configured to provide an ambient temperature for the drive circuit.

In an embodiment, when controlling the level output unit 602 to output the first level to the inverter N1, the controller 601 is further configured to:

adjust a temperature of the temperature control layer 603 to be higher than a first preset temperature, where the first preset temperature is an operating temperature of the drive circuit.

In an embodiment, when controlling the level output unit 602 to output the second level to the inverter N1, the controller 601 is further configured to:

adjust the temperature of the temperature control layer 603 to be higher than and lower than a second preset temperature, where the second preset temperature is a normal temperature.

Based on a same technical concept, an embodiment of this application further provides a computer device. As shown in FIG. 8, the computer device includes a processor 801 and a memory 802. The memory 802 stores a computer program. When executing the computer program, the processor 801 implements any one of the foregoing aging detection methods.

For example, the processor 801 may be a central processing unit (central processing unit, CPU), or may be another general-purpose processor, a digital signal processor (digital signal processor, DSP), an application-specific integrated circuit (application specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, or the processor may be any conventional processor or the like.

It should be noted that the memory 802 mentioned in embodiments of this application may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of an example but not limitative descriptions, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

It should be noted that when the processor 801 is a general-purpose processor, a DSP, an ASIC, an FPGA or another programmable logical device, a discrete gate or a transistor logical device, or a discrete hardware component, the memory 802 (a storage module) may be integrated into the processor.

It should be noted that the memory 802 described in this specification aims to include but is not limited to these memories and any memory of another proper type.

Based on a same technical concept, an embodiment of this application further provides a computer storage medium, including a program or instructions. When the program or the instructions are run on a computer, any one of the foregoing methods is performed.

Based on a same technical concept, an embodiment of this application further provides a chip. The chip is coupled to a memory, and is configured to read and execute program instructions stored in the memory, so that any one of the foregoing methods is performed.

Based on a same technical concept, an embodiment of this application further provides a computer program product, including instructions. When the instructions are run on a computer, any one of the foregoing methods is performed.

It should be noted that all related content of the steps in the foregoing method embodiments may be cited in function description of corresponding functional modules. Details are not described herein again.

A person skilled in the art should understand that embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to this application. It should be noted that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer-readable memory that can instruct the computer or any other programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams.

The computer program instructions may alternatively be loaded onto a computer or another programmable data processing device, so that a series of operations and steps are performed on the computer or the another programmable device, so that computer-implemented processing is generated. Therefore, the instructions executed on the computer or the another programmable device provide steps for implementing a specific function in one or more procedures in the flowcharts and/or in one or more blocks in the block diagrams.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1.   A chip aging method, wherein a drive circuit of the chip comprises an inverter and at least one selection transistor;

an aging apparatus is connected to an input end of the inverter and a gate of the at least one selection transistor, an output end of the inverter is connected to a drain of the at least one selection transistor, a first power supply end of the inverter is connected to a high voltage, and a second power supply end of the inverter and a source of each selection transistor are connected to a low voltage; and
the aging method comprises:

outputting, by the aging apparatus, a first level to the inverter, wherein the first level is used to form a direct current field between the input end and the output end of the inverter; or
the aging method comprises:

outputting, by the aging apparatus, a second level to the inverter, wherein the second level is used to control a path between the first power supply end and the output end to be connected, and
outputting a third level to the gate of the selection transistor, wherein the third level is used to form a direct current field between the source and the drain of the selection transistor.

2. The method according to claim 1, wherein when the aging apparatus outputs the first level to the inverter, the method further comprises:
outputting, by the aging apparatus, a fourth level to the gate of the selection transistor, wherein the fourth level is used to control a path between the source and the drain of the selection transistor to be disconnected.

3. The method according to claim 1 or 2, wherein when the aging apparatus outputs the first level to the inverter, the method further comprises:
adjusting, by the aging apparatus, an ambient temperature of the drive circuit to be higher than a first preset temperature, wherein the first preset temperature is an operating temperature of the drive circuit.

4. The method according to any one of claims 1 to 3, wherein when the aging apparatus outputs the second level to the inverter, the method further comprises:
adjusting, by the aging apparatus, the ambient temperature of the drive circuit to be lower than a second preset temperature, wherein the second preset temperature is a normal temperature.

5. A chip aging method, wherein a drive circuit of the chip comprises an inverter, a position decoder, and at least one selection transistor;

an aging apparatus is connected to an input end of the inverter and a first end of the position decoder, a second end of the position decoder is connected to a gate of the at least one selection transistor, an output end of the inverter is connected to a drain of the at least one selection transistor, a first power supply end of the inverter is connected to a high voltage, and a second power supply end of the inverter and a source of each selection transistor are connected to a low voltage; and
the aging method comprises:

outputting, by the aging apparatus, a first level to the inverter, wherein the first level is used to form a direct current field between the input end and the output end of the inverter; or
the aging method comprises:

outputting, by the aging apparatus, a second level to the inverter, wherein the second level is used to control a path between the first power supply end and the output end to be connected, and
controlling the position decoder to output a third level to the gate of the selection transistor, wherein the third level is used to form a direct current field between the source and the drain of the selection transistor.

6. The method according to claim 5, wherein when the aging apparatus outputs the first level to the inverter, the method further comprises:
controlling, by the aging apparatus, the position decoder to output a fourth level to the gate of the selection transistor, wherein the fourth level is used to control a path between the source and the drain of the selection transistor to be disconnected.

7. The method according to claim 5 or 6, wherein when the aging apparatus outputs the first level to the inverter, the method further comprises:
adjusting, by the aging apparatus, an ambient temperature of the drive circuit to be higher than a first preset temperature, wherein the first preset temperature is an operating temperature of the drive circuit.

8. The method according to any one of claims 5 to 7, wherein when the aging apparatus outputs the second level to the inverter, the method further comprises:
adjusting, by the aging apparatus, the ambient temperature of the drive circuit to be lower than a second preset temperature, wherein the second preset temperature is a normal temperature.

9. An aging apparatus, wherein the aging apparatus comprises a controller and a level output unit, and the aging apparatus is connected to a drive circuit of a chip;

> the drive circuit comprises an inverter and at least one selection transistor;
> the controller is connected to the level output unit, the level output unit is connected to an input end of the inverter and a gate of the at least one selection transistor, an output end of the inverter is connected to a drain of the at least one selection transistor, a first power supply end of the inverter is connected to a high voltage, and a second power supply end of the inverter and a source of each selection transistor are connected to a low voltage;
> the level output unit is configured to output a level; and
> the controller is configured to control the level output unit to output a first level to the inverter, wherein the first level is used to form a direct current field between the input end and the output end of the inverter;
> or
> the controller is configured to: control the level output unit to output a second level to the inverter, wherein the second level is used to control a path between the first power supply end and the output end to be connected, and control the level output unit to output a third level to the gate of the selection transistor, wherein the third level is used to form a direct current field between the source and the drain of the selection transistor.

10. The apparatus according to claim 9, wherein when controlling the level output unit to output the first level to the inverter, the controller is further configured to:
control the level output unit to output a fourth level to the gate of the selection transistor, wherein the fourth level is used to control a path between the source and the drain of the selection transistor to be disconnected.

11. The apparatus according to claim 9 or 10, wherein the aging apparatus further comprises a temperature control layer, and the temperature control layer is configured to provide an ambient temperature for the drive circuit.

12. The apparatus according to claim 11, wherein when controlling the level output unit to output the first level to the inverter, the controller is further configured to:
adjust a temperature of the temperature control layer to be higher than a first preset temperature, wherein the first preset temperature is an operating temperature of the drive circuit.

13. The apparatus according to claim 11 or 12, wherein when controlling the level output unit to output the second level to the inverter, the controller is further configured to:
adjust the temperature of the temperature control layer to be higher than and lower than a second preset temperature, wherein the second preset temperature is a normal temperature.

14. An aging apparatus, wherein the aging apparatus comprises a controller and a level output unit, and the aging apparatus is connected to a drive circuit of a chip;

> the drive circuit comprises an inverter, a position decoder, and at least one selection transistor;
> the controller is connected to the level output unit and a first end of the position decoder, a second end of the position decoder is connected to a gate of the at least one selection transistor, the level output unit is connected to an input end of the inverter, an output end of the inverter is connected to a drain of the at least one selection transistor, a first power supply end of the inverter is connected to a high voltage, and a second power supply end of the inverter and a source of each selection transistor are connected to a low voltage;
> the level output unit is configured to output a level; and
> the controller is configured to control the level output unit to output a first level to the inverter, wherein the first level is used to form a direct current field between the input end and the output end of the inverter;
> or
> the controller is configured to: control the level output unit to output a second level to the inverter, wherein the second level is used to control a path between the first power supply end and the output end to be connected, and control the position decoder to output a third level to the gate of the selection transistor, wherein the third level is used to form a direct current field between the source and the drain of the selection transistor.

15. The apparatus according to claim 14, wherein when controlling the level output unit to output the first level to the inverter, the controller is further configured to:
control the position decoder to output a fourth level to the gate of the selection transistor, wherein the fourth level is used to control a path between the source and the drain of the selection transistor to be disconnected.

16. The apparatus according to claim 14 or 15, wherein the aging apparatus further comprises a temperature control layer, and the temperature control layer is configured to provide an ambient temperature for the drive circuit.

17. The apparatus according to claim 16, wherein when controlling the level output unit to output the first level to the inverter, the controller is further configured to:
adjust a temperature of the temperature control layer to be higher than a first preset temperature, wherein the first preset temperature is an operating temperature of the drive circuit.

18. The apparatus according to claim 16 or 17, wherein when controlling the level output unit to output the second level to the inverter, the controller is further configured to:
adjust the temperature of the temperature control layer to be higher than and lower than a second preset temperature, wherein the second preset temperature is a normal temperature.

FIG. 1

EP 4 671 777 A1

FIG. 2

FIG. 3

FIG. 4

FIG. 5

FIG. 6

603

Temperature control layer

Drive circuit

Vhigh

N1

M1

601

602

Controller

Level output unit

Inverter

Vbb

Vbb

501

Position decoder

Mn

FIG. 7

801

802

Processor

Memory

FIG. 8

## INTERNATIONAL SEARCH REPORT

| International application No. |
| --- |
| **PCT/CN2023/141457** |

| A. | CLASSIFICATION OF SUBJECT MATTER |
| --- | --- |

G01R31/28(2006.01)i

According to International Patent Classification (IPC) or to both national classification and IPC

| B. | FIELDS SEARCHED |
| --- | --- |

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNTXT: CNKI; ENTXTC; ENTXT; VEN: 芯片, IC, 集成电路, 存储器, 老化, 倒相, 反相, 反向器, 晶体管, MOS管, 开关管, 失效, chip, integrated circuit, aging, inverter, transistor, fault, invalidation

| C. | DOCUMENTS CONSIDERED TO BE RELEVANT | | |
| --- | --- | --- |
| Category* | Citation of document, with indication, where appropriate, of the relevant passages | Relevant to claim No. |
| A | CN 1116710 A (SAMSUNG ELECTRONICS CO., LTD.) 14 February 1996 (1996-02-14) description, page 4, line 6-page 6, line 5, and figure 4 | 1-18 |
| A | CN 114487790 A (HYGON INFORMATION TECHNOLOGY CO., LTD.) 13 May 2022 (2022-05-13) entire document | 1-18 |
| A | JP H0963269 A (HITACHI LTD. et al.) 07 March 1997 (1997-03-07) entire document | 1-18 |
| A | US 2007165470 A1 (SAMSUNG ELECTRONICS CO., LTD.) 19 July 2007 (2007-07-19) entire document | 1-18 |
| A | US 5119337 A (TOSHIBA K.K.) 02 June 1992 (1992-06-02) entire document | 1-18 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **01 April 2024** | **01 April 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2023/141457** |

| Patent document cited in search report | | | Publication date (day/month/year) | Patent family member(s) | | | Publication date (day/month/year) |
| --- | --- | --- | --- | --- | --- | --- | --- |
| CN | 1116710 | A | 14 February 1996 | DE | 19520630 | A1 | 14 March 1996 |
| | | | | US | 5590079 | A | 31 December 1996 |
| | | | | TW | 263562 | B | 21 November 1995 |
| | | | | KR | 960002369 | A | 26 January 1996 |
| | | | | KR | 0119887 | B1 | 30 October 1997 |
| | | | | JPH | 0855497 | A | 27 February 1996 |
| | | | | JP | 2738517 | B2 | 08 April 1998 |
| CN | 114487790 | A | 13 May 2022 | None | | | |
| JP | H0963269 | A | 07 March 1997 | None | | | |
| US | 2007165470 | A1 | 19 July 2007 | US | 7480196 | B2 | 20 January 2009 |
| | | | | KR | 100671752 | B1 | 19 January 2007 |
| US | 5119337 | A | 02 June 1992 | DE | 69011738 | D1 | 29 September 1994 |
| | | | | DE | 69011738 | T2 | 02 February 1995 |
| | | | | EP | 0399240 | A2 | 28 November 1990 |
| | | | | EP | 0399240 | B1 | 24 August 1994 |
| | | | | JPH | 02306493 | A | 19 December 1990 |
| | | | | JPH | 07105160 | B2 | 13 November 1995 |
| | | | | KR | 900019039 | A | 22 December 1990 |
| | | | | KR | 930004177 | B1 | 21 May 1993 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310261232